Europäisches Patentamt

European Patent Office

Office européen des brevets

(19)

(11) Publication number:  **0 151 948 B1**

## EUROPEAN PATENT SPECIFICATION

(12)

(45) Date of publication of patent specification: **09.10.91**  (51) Int. Cl.⁵: **H01L 21/306**

(21) Application number: **85100406.9**

(22) Date of filing: **17.01.85**

(54) **Control of etch rate ratio of sio2/photoresist for quartz planarization etch back process.**

(30) Priority: **30.01.84 US 575118**

(43) Date of publication of application:
**21.08.85 Bulletin 85/34**

(45) Publication of the grant of the patent:
**09.10.91 Bulletin 91/41**

(84) Designated Contracting States:
**DE FR GB**

(56) References cited:
**EP-A- 0 054 164**
**EP-A- 0 098 775**
**GB-A- 2 119 166**
**US-A- 3 867 216**
**US-A- 4 324 611**

(73) Proprietor: **International Business Machines Corporation**
**Old Orchard Road**
**Armonk, N.Y. 10504(US)**

(72) Inventor: **Chen, Lee**
**2 Vincent Road**
**Poughkeepsie New York 12603(US)**
Inventor: **Mathad, Gangadhara Swami**
**5 Spurway**
**Poughkeepsie New York(US)**

(74) Representative: **Mönig, Anton, Dipl.-Ing.**
**IBM Deutschland GmbH Patentwesen und**
**Urheberrecht Schönaicher Strasse 220**
**W-7030 Böblingen(DE)**

## Description

The invention relates to a semiconductor etch back process and more particularly to a method of controlling the etch rate ratio of $SiO_2$/photoresist in a quartz planarization etch back process.

In large scale integration (LSI) logic products metallurgy structures are positioned on several levels. In order to accurately interconnect these multilevel metallurgy structures, it is necessary to planarize each metallurgical structure level. As a result, obtaining a planar topography in multilevel metallization structures is a problem. One way to remove the topography in order to planarize a particular metallization level, is by the etch back process. The etch back process requires an etch rate ratio of $SiO_2$/photoresist to be 1.2 ± 0.1. The present etching techniques prior to this invention have not been able to achieve the desired etch back ratio at high etch rates and with tight tolerances.

U.S. patent 4,324,611 describes an etching process for etching silicon dioxide and/or silicon nitride using a primary etching gas selected from the group consisting of $C_2F_6$, $CF_4$, $C_3F_8$ , $C_4F_{10}$, $C_4F_8$, and combinations thereof and a secondary gas selected from the group consisting of $CHF_3$, hydrogen, $CF_4$ plus hydrogen, and combinations thereof. The chamber pressure is on the order of 1.33 to 4 mbar when the primary gas is added. The addition of the secondary gas adds an additional 0.67 to 2 mbar of pressure to the system. A third gas, such as helium, is added at a pressure of the order of 6.65 mbar, when it is desired to prevent photoresist breakdown. This patent does not suggest a planarization process involving organic polymeric materials such as photoresist and silicon dioxide.

Other U.S. patents 3,940,506 and 4,344,816, suggest the use of combinations of $CF_4$ and $CHF_3$ gases but again not for the same purpose and not at the same pressures and composition in the gaseous reactive plasma.

UK patent application GB-A-2 119 166 relates to an integrated circuit planarizing process which comprises

1. depositing a first dielectric layer being comprised of silicon dioxide or nitride over first metal conductors;
2. depositing and polymerizing a layer of negative isoprene resist over the surface of the dielectric layer;
3. etching the surface of the isoprene and dielectric layers to a predetermined thickness over the metal conductors;
4. cleaning the etched surface and depositing a second dielectric layer being comprised of silicon dioxide or nitride over the surface.

In this process, the negative isoprene resist layer is etched in a plasma of about 32 to 50 % oxygen in a gas of $CF_4$. This oxygen level provides uniform etching and similar etch rates between the dielectric layer and the negative isoprene resist layer.

The primary object of this invention is to provide an improved quartz planarization etch back process and in particular to provide a method of controlling the etch rate ratio of $SiO_2$/photoresist (PR).

These and other objects are accomplished by an etching method that involves contacting at a pressure of not less than 0.67 mbar the surface which includes both silicon dioxide and an organic polymer material with a reactive etching plasma which contains $CF_4$ and a gas taken from the group consisting of $CHF_3$, $C_xF_y$ with x > 1 to cause the structure formed by said etching step to be substantially planar and provide an etch rate ratio of 1.2 ± 0.1.

The preferred $SiO_2$/PR ratio of 1 is obtained by adding $CHF_3$ to decrease the etch rate of the PR or by adding $O_2$ to increase the etch rate of the PR. In one preferred embodiment using a single wafer reactor to etch $SiO_2$ covered with a commercial photoresist (AZ) a gaseous mixture containing 97.5 % $CF_4$, 2.5 % $CHF_3$ and 0 % oxygen provided an etch rate ratio of 1.096 whereas a gaseous mixture containing 97.0 % $CF_4$, 3 % $CHF_3$ and 0 % oxygen yields an etch rate ratio of 1.196.

The advantages of the invention will be apparent from the following detailed description, reference being made to the following drawings in which a specific embodiment of the invention is shown.

FIGURE 1   is a cross-sectional view of the $SiO_2$/photoresist system to be etched in accordance with this invention;

FIGURE 2   is a cross-sectional view showing the planarized structure obtained in accordance with the etching process of this invention.

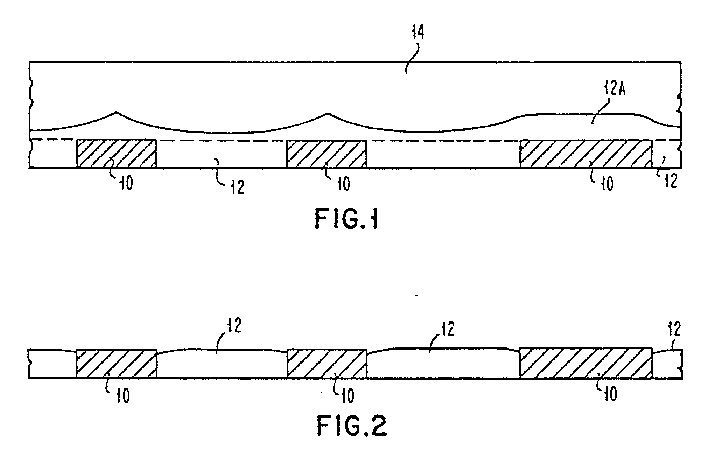

The method of controlling the etch rate ratio of $SiO_2$/photoresist in a quartz planar etch back process includes the step of etching with a gaseous mixture containing $CF_4$ and either $CHF_3$ or $C_xF_y$ with x > 1 or $O_2$. As shown in Fig. 1, topographical features 10, for example a metal such as copper, aluminum and the like, are covered with a rough substrate such as $SiO_2$ 12A. The purpose of this invention is to planarize the surface of the $SiO_2$ 12 that it is substantially planar or flat between the metal features 10 as shown in Fig. 2.

The structure shown in Fig. 2 is obtained with a process in accordance with this invention that involves

2

etching a layer 14 of a photoresist material, i.e. an organic polymer material, which is positioned over the $SiO_2$ layer 12 as shown in Fig. 1. It is desired to etch uniformly through the resist layer 14 and the $SiO_2$ layer 12A with an etch rate ratio of $1.2 \pm 0.1$ such that metal just sticks out of the $SiO_2$ surface. The etch rate ratio is defined as the etch rate of the oxide, $SiO_2$, over the etch rate of the photoresist. When a calculated etch rate ratio of $1.2 \pm 0.1$ is obtained, then a planar structure such as shown in Fig. 2 is produced. Since the etch rate of different photoresists varies significantly, it is difficult to find one set of conditions that is suitable for more than one photoresist. In addition, the etch rates of the $SiO_2$ and photoresist vary significantly depending upon the apparatus and equipment used.

In accordance with this invention an etch rate ratio of $1.2 \pm 0.1$ is obtained by etching the structure shown in Fig. 1 with a gaseous mixture at a pressure of not less than 0.67 mbar containing $CF_4$ and either $CHF_3$ or $C_xF_y$ with $x > 1$ or oxygen. The composition of the gaseous mixture depends upon the etching characteristics of the photoresist material used in layer 14. The composition of the gaseous mixture contains an etching gas, a polymerizing gas and, if necessary, an oxidizing gas to achieve a balance between surface etching, gas phase polymerization and surface oxidation reactions. The $CF_4$ gas is the primary gas for etching $SiO_2$. The $CHF_3$ or $C_xF_y$ with $x > 1$ gas is primarily added to decrease the etch rate of the photoresist. The $CHF_3$ or $C_xF_y$ with $x > 1$ gas is a polymerizing gas for the control of gas phase polymerization. The $C_xF_y$ with $x > 1$ gas is unsaturated. Examples of such a gas are $C_2F_4$ and $C_2F_6$. The $O_2$ gas is used primarily to increase the etch rate of the resist. The oxygen gas is for controlling surface oxidation of the polymer that is deposited by the second gas ($CHF_3$). The combination of these gases provides a wide latitude in achieving etch rate ratios so that the planarization objectives can be easily met even with varying photoresist properties.

The following examples illustrate the effect of $CHF_3$ on the etch rate ratio.

| EXAMPLE No. | % CF$_4$ | % CHF$_3$ | % O$_2$ | PR | Estimated Over All ERR | Planarity Satisfactory |
|---|---|---|---|---|---|---|
| 1 | 100.0 | 0 | 0 | AZ1350J* | 0.860 | No |
| 2 | 99.0 | 1 | 0 | AZ1350J | 0.989 | No |
| 3 | 98.5 | 1.5 | 0 | AZ1350J | 1.017 | No |
| 4 | 97.5 | 2.5 | 0 | AZ1350J | 1.096 | Yes |
| 5 | 97.0 | 3 | 0 | AZ1350J | 1.196 | Yes |
| 6 | 95.0 | 5 | 0 | AZ1350J | 1.570 | No |
| 7 | 100.0 | 0 | 0 | HC* | 0.95 | No |
| 8 | 80 | 20 | 0 | HC | 2.5 | No |
| 9 | 70 | 30 | 0 | HC | 1.7 | No |
| 10 | 80 | 20 | 0 | HC | 1.3 | Yes |
| 11 | 90 | 10 | 0 | HC | 1.2 | Yes |

\* 1.2-naphthoquinone diazide sensitized phenol-formaldehyde resin

**Claims**

1. Method for uniformly etching a surface which includes both silicon dioxide and an organic polymer material comprising the steps of

contacting said surface at a pressure of not less than 0.67 mbar with a reactive etching plasma which contains $CF_4$ and a gas taken from the group consisting of $CHF_3$, $C_xF_y$ with x > 1, to cause the structure formed by said etching step to be substantially planar and provide an etch rate ratio of 1.2 ± 0.1.

2. Method as described in claim 2 whereby said etching plasma contains $CHF_3$.

3. Method as described in claim 2 whereby the gaseous mixture contains 0.5 to 5.0 % $CHF_3$.

**Revendications**

1. Procédé pour attaquer uniformément une surface qui comprend à la fois du dioxyde de silicium et un matériau polymère organique, caractérisé en ce qu'il comprend l'étape de mise en contact de cette surface à une pression d'au moins 0,67 mbar, avec un plasma d'attaque réactif qui contient du $CF_4$ et un gaz choisi parmi $CHF_3$, $C_xF_y$ avec x > 1, pour que la structure formée par cette étape d'attaque soit pratiquement plane et que le rapport de vitesses d'attaque soit de 1,2 ± 0,1.

2. Procédé suivant la revendication 1, caractérisé en ce que ce plasma d'attaque contient du $CHF_3$.

3. Procédé suivant la revendication 2, caractérisé en ce que le mélange gazeux contient 0,5 à 5,0% de $CHF_3$.

**Patentansprüche**

1. Verfahren zum gleichmäßigen Ätzen einer Oberfläche, die sowohl aus Siliziumdioxid als auch aus einem organischem Polymer besteht, umfassend die Schritte

Behandlung der Oberfläche bei einem Druck nicht unter 0.67 mbar mit einer reaktiven Ätzplama, welches $CF_4$ und ein Gas aus der Gruppe $CHF_3$, $C_xF_y$ mit x > 1 enthält, um zu bewirken, daß die durch diesen Ätzschritt erzeugte Struktur planar ist und ein Ätzratenverhältnis von 1.2 ± 0.1 erreicht wird.

2. Verfahren wie in Anspruch 1 beschrieben, wobei das Ätzplasma $CHF_3$ enthält.

3. Verfahren wie in Anspruch 2 beschrieben, wobei die Ätzgasmischung 0.5 bis 5.0% $CHF_3$ enthält.

4

FIG.1

FIG.2